(19) **Europäisches Patentamt**

**European Patent Office**

**Office européen des brevets**

(11) Veröffentlichungsnummer: **0 268 166 B1**

(12) # EUROPÄISCHE PATENTSCHRIFT

(45) Veröffentlichungstag der Patentschrift: **27.01.93**

(21) Anmeldenummer: **87116400.0**

(22) Anmeldetag: **06.11.87**

(51) Int. Cl.⁵: **C04B 35/65**, B22D 41/00, C04B 35/58

(54) **Gegenüber Metall- und Salzschmelzen resistente Werkstoffe, ihre Herstellung und deren Verwendung.**

(30) Priorität: **18.11.86 DE 3639335**

(43) Veröffentlichungstag der Anmeldung:
**25.05.88 Patentblatt 88/21**

(45) Bekanntmachung des Hinweises auf die
Patenterteilung:
**27.01.93 Patentblatt 93/04**

(84) Benannte Vertragsstaaten:
**BE CH DE FR GB IT LI NL**

(56) Entgegenhaltungen:
**DE-B- 1 646 785**
**FR-A- 2 318 840**

(73) Patentinhaber: **BAYER AG**

**W-5090 Leverkusen 1 Bayerwerk(DE)**

(72) Erfinder: **Woditsch, Peter, Dr.**
**Deswatinesstrasse 83**
**W-4150 Krefeld(DE)**
Erfinder: **Kannchen, Werner**
**Schumannstrasse 14**
**W-4100 Duisburg 46(DE)**
Erfinder: **Lange, Horst, Dr.**
**Breslauer Strasse 31**
**W-4150 Krefeld(DE)**
Erfinder: **Schwirtlich, Ingo, Dr.**
**Hausweberstrasse 26**
**W-4150 Krefeld(DE)**

EP 0 268 166 B1

**Beschreibung**

Die vorliegende Erfindung betrifft Werkstoffe, die gegenüber Metallschmelzen und Salzschmelzen resistent sind, weiterhin betrifft sie die Herstellung dieser Werkstoffe und deren Verwendung.

Die Herstellung kostengünstiger Solarzellen auf der Basis kristallinen Siliciums erfordert gegenüber dem heutigen Preisniveau eine deutliche Kostenreduktion. Dabei muß von der Herstellung eines chemisch ausreichend reinen Siliciums über den Kristallisationsprozeß bis zur Formgebung der Zellen eine neue Technologie entwickelt werden.

Formteile aus hochreinem Quarz sind kommerziell erhältlich. Da Quarz zu den Materialien gehört, die chemisch sehr reine Metallschmelzen nur wenig verunreinigen, wird es vorzugsweise als Tiegelmaterial in Czochralski-Ziehanlagen bei der Herstellung von Reinstsilicium verwendet. Dagegen ist die Anwendung von Quarzkokillen zur Kristallisation von Siliciumschmelzen problematisch.

Quarz besitzt mit ca. $5,5 \cdot 10^{-7}$ gegenüber Silicium mit $3 \cdot 10^{-6} \cdot C^{-1}$ einen um den Faktor 10 geringeren thermischen linearen Ausdehnungskoeffizienten. Da sich Silicium beim Erstarren fest mit den Wänden der Quarzkokille verbindet, werden beim Erstarren und Abkühlen des Siliciumblocks Spannungen erzeugt, die zu Rissen im Siliciumblock und Bruch der Quarzkokille führen. Ferner neigen Quarzgefäße beim Abkühlen aus dem erforderlichen Temperaturbereich zum Entglasen und zerspringen. Sie sind daher nicht wiederverwendbar und tragen aufgrund ihrer hohen Kosten zur Erhöhung der Gesamtkosten des Siliciumkristallisationsverfahrens wesentlich bei.

Um einen direkten Kontakt der Siliciumschmelze mit der Quarzwand und damit ein Zusammenbacken von Siliciumblock und Quarztiegel zu vermeiden, wurden Siliciumnitridbeschichtete Quarztiegel vorgeschlagen [T. Saito, A. Shimura, S. Ishikawa, Solar Energy Materials 9, 337-345 (1983)].

Infolge Entglasung sind aber auch derart beschichtete Materialien zur Wiederverwendung nur bedingt geeignet. Eine weitere Anwendungsgrenze von Quarzformteilen tritt durch zunehmende Erweichung des Materials mit steigender Temperatur der Siliciumschmelze auf, so daß bei ca. 1500°C eine praktische Grenze für die Anwendung von Quarzgeräten zur Handhabung von Siliciumschmelzen erreicht ist.

Höhere Temperaturen können mit Graphit erreicht werden; da dieses Material zudem sehr leicht bearbeitet werden kann, erscheint seine Anwendung zur Handhabung von Metallschmelzen sehr attraktiv. Graphitqualitäten hoher Dichte, gut ausgeprägter Kristallinität und relativ geringer offener Porosität sind kommerziell erhältlich und besitzen eine ausreichende Resistenz gegenüber Siliciumschmelzen.

Beim Kontakt mit flüssigem Silicium bildet Graphit eine dünne SiC-Schicht. Durch das Eindiffundieren von Kohlenstoff in die Schmelze bilden sich bei Überschreiten der Löslichkeitsgrenze SiC-Ausscheidungen. Es ist ein bekanntes Phänomen, daß SiC-Ausscheidungen den Wirkungsgrad der Solarzellen erheblich herabsetzen.

Dichtgesinterte Siliciumnitrid-Formteile können durch Heißpressen von $Si_3N_4$ unter Verwendung von Sinteradditiven hergestellt werden. Die Verfahren sind jedoch aufwendig und kostspielig, so daß derart hergestellte Formteile zur Kostenreduktion bei der Handhabung von Siliciumschmelzen nicht beitragen können.

Ein allgemeiner Nachteil der $Si_3N_4$-Keramik ist, daß eine Nachbehandlung der Formteile nur noch mit Diamantwerkzeugen möglich und damit aufwendig und kostenintensiv ist.

Aus den DE-B-16 46 785 und FR-A-23 18 849 sind Werkstoffe bekannt, die als Bestandteile Siliciumnitrid, Siliciumoxynitrid, Siliciumdioxid und Silicium enthalten. Bei deren Herstellung werden Erdalkalioxide und -fluoride zur Beschleunigung des Nitrierprozesses zugegeben. Die Erdalkalionen finden sich in den fertigen Werkstoffen wieder.

Zur wirksamen Kostenreduktion eines Verfahrens zur Handhabung von Silicium, insbesondere bei Schmelz- und Kristallisationsprozessen, stellte sich daher die Aufgabe, alternativ zu den bisher eingesetzten kostspieligen Materialien Quarz, Kohlenstoff und $Si_3N_4$-Keramik mit ihren oben beschriebenen Nachteilen einen neuen, kostengünstigen und einfach herzustellenden Werkstoff zu suchen, der diese Nachteile nicht aufweist.

Diese Anforderungen werden in hervorragender Weise erfüllt durch den im folgenden beschriebenen erfindungsgemäßen Werkstoff.

Der Werkstoff ist aus $\alpha$- und $\beta$-Siliciumnitrid, Siliciumoxynitrid, Siliciumdioxid und elementarem Silicium zusammengesetzt und ist damit durch mehrere nebeneinander vorliegende Phasen charakterisiert.

Gegenstand dieser Erfindung sind somit Werkstoffe, die gegenüber Metallschmelzen und Salzschmelzen resistent sind, welche dadurch gekennzeichnet sind, daß sie zu 40-90 Gew.-% aus Siliciumnitrid, 2-20 Gew.-% Siliciumdioxid, 2-20 Gew.-% Siliciumoxynitrid und 2-20 Gew.-% elementarem Silicium bestehen. Weiterhin Gegenstand dieser Erfindung sind Werkstoffe, die gegenüber Metallschmelzen und Salzschmelzen resistent sind, dadurch gekennzeichnet, daß sie zu 40-90 Gew.-% aus Siliciumnitrid, 2-20 Gew.-%

2

Siliciumdioxid, 2-20 Gew.-% Siliciumoxynitrid, 2-20 % elementarem Silicium und 15-30 Gew.-% Siliciumcarbid bestehen.

Je nach Art der mit dem Werkstoff in Kontakt stehenden Salz- und Metallschmelze kann es vorteilhaft sein, über die Mengenanteile Siliciumnitrid, Siliciumoxynitrid, Siliciumdioxid und Siliciumcarbid Einfluß auf die Benetzbarkeit und Korrosionsanfälligkeit des Formteiles zu nehmen. So ist bekannt, daß Siliciumdioxid durch fluorid- oder hydrogenfluoridhaltige Schmelzen stark angegriffen wird, während Siliciumcarbid und Siliciumnitrid beständiger sind. Es ist ferner bekannt, daß Siliciumdioxid mit flüssigem Silicium zu flüchtigem Siliciummonoxid reagiert. Andererseits wird Siliciumdioxid durch eine Siliciumschmelze schlecht, Siliciumnitrid und Siliciumcarbid dagegen relativ gut benetzt. Da Siliciumdioxid im Bereich über 1300°C allmählich erweicht, verleihen höhere Anteile Siliciumnitrid und Siliciumoxinitrid, die durch Reaktionssintern gebildet werden können, dem Formteil in diesem Temperaturbereich eine höhere Stabilität gegenüber Deformationen.

Ja nach Einsatzgebiet der erfindungsgemäßen Werkstoffe können sie auch Siliciumcarbid als weitere Phase enthalten. Eine weitere vorteilhaftere Ausführungsform der erfindungsgemäßen Werkstoffe ist also dadurch gekennzeichnet, daß sie zusätzlich Siliciumcarbid in Mengen bis zu 60 Gew.-%, vorzugsweise 15 bis 30 Gew.-%, enthalten.

Die erfindungsgemäßen Werkstoffe sind eindeutig mit Hilfe der Röntgenpulverdiffraktometrie zu identifizieren. Bei einem Substanzgemisch erscheinen die Interferenzlinien der Komponenten nebeneinander im Diffraktogramm. Aus der Lage der Interferenzlinien lassen sich Beugungswinkel und gemäß der Bragg'schen Gleichung

$$n \cdot \lambda = 2\,d \sin \alpha$$

$n = \quad 1, 2, 3, 4, \ldots$
$\lambda = \quad$ Röntgenwellenlänge
$\alpha = \quad$ Beugungswinkel

die Netzebenenabstände d bestimmen. Die erfindungsgemäß hergestellten Werkstoffe werden damit am besten durch ihre kristallographischen d-Werte charakterisiert. Es müssen folgende Reflexe stets vorhanden sein:

## d-Werte

| | | | | |
|---|---|---|---|---|
| 6,603 | 2,803 | 2,150 | 1,543 | 1,314 |
| 4,677 | 2,655 | 2,074 | 1,507 | 1,296 |
| 4,427 | 2,587 | 1,917 | 1,482 | 1,285 |
| 4,308 | 2,533 | 1,894 | 1,450 | 1,264 |
| 3,874 | 2,484 | 1,822 | 1,433 | 1,252 |
| 3,798 | 2,419 | 1,800 | 1,415 | |
| 3,354 | 2,386 | 1,763 | 1,402 | |
| 3,287 | 2,307 | 1,748 | 1,346 | |
| 3,129 | 2,270 | 1,633 | 1,337 | |
| 2,876 | 2,175 | 1,588 | 1,328 | |

Hier sind die d-Werte des Siliciumcarbids, das als zusätzliche Phase vorhanden sein kann, nicht aufgeführt.

Gegenstand der vorliegenden Erfindung sind auch Verfahren zur Herstellung der erfindungsgemäßen Werkstoffe.

Die Herstellung geschieht im wesentlichen dadurch, Siliciumpulver mit $SiO_2$-Solen zu einer gießfähigen Masse zu verarbeiten und diese nach Zusatz von Substanzen, die zur Gelierung der $SiO_2$-Sole führen, in einer Form auszuhärten. Auf diese Weise sind Formteile beliebiger Gestalt herstellbar.

Das erfindungsgemäße Verfahren ist dadurch gekennzeichnet, daß Siliciumpulver in $SiO_2$-Sol unter Bildung einer Gießmasse suspendiert, aus dieser ein Werkstück geformt, dieses ausgehärtet und nach dem Ausformen des $SiO_2$-gebundenen Siliciums dieses unter Stickstoffatmosphäre zu Siliciumnitrid und Siliciumoxynitrid so umgesetzt wird, daß im nitridierten Werkstück $SiO_2$ und elementares Silicium nachweisbar bleiben, wobei diese Aushärtung der Gießmasse ggf. unter Einsatz von Säuren, Basen, Fluoriden, Erdalkalioxiden und/oder Ammoniumsalzen geschehen kann, wobei diese im Laufe des Verfahrens rückstandslos ausgeheizt werden.

Das besondere an dem hier beanspruchten Verfahren ist die Verwendung von $SiO_2$-Solen, die durch Elektrolytzusatz geliert werden können. Im einfachsten Verarbeitungsfall dispergiert man das Siliciumpulver im $SiO_2$-Sol, setzt einen Elektrolyten zu und gießt die Suspension in eine vorgegebene Form.

Nach einigen Minuten härtet die Suspension aus und der gegossene Formkörper kann problemlos ausgeformt werden.

Die zur Aushärtung erforderliche Zeit ist dabei in weiten Grenzen durch Art und Menge des Elektrolytzusatzes, durch die Konzentration des $SiO_2$-Sols sowie durch das Verhältnis von Siliciumpulver zu $SiO_2$-Sol und Elektrolyt einstellbar.

Der anschließende Trockenprozeß muß relativ langsam erfolgen, um keine Risse durch Schrumpfprozesse zu verursachen. Das so erhaltene Formteil wird aufgeheizt und in einer stickstoffhaltigen Atmosphäre zu dem eingangs charakterisierten Werkstoff nitridiert.

Die Trocknung der geformten Werkstücke erfolgt am besten bei Temperaturen zwischen 50 und 350°C unter reduziertem Druck.

Das vorhandene $SiO_2$ wandelt sich dabei teilweise zu Siliciumoxynitriden um; bei hoher Konzentration kann es sich während der Nitridierung an der Formteiloberfläche anreichern, so daß eine Glasur entsteht.

Die Gehalte an freiem Silicium in den erfindungsgemäßen Formkörpern erweisen sich bei deren Einsatz, z. B. der Kristallisation von flüssigem Silicium, als unkritisch.

Eine besondere Variante der Formteilherstellung ergibt sich dadurch, daß gegenüber einer Umsetzung mit Stickstoff inerte Materialien der gießfähigen Suspension zugesetzt werden können. Von besonderem Vorteil ist dabei die Verwendung reiner Siliciumverbindungen wie $\alpha$- und $\beta$-Siliciumnitrid, Siliciumcarbid, Siliciumoxynitrid und/oder Siliciumdioxid. Eine hohe Wirtschaftlichkeit ergibt sich, indem ausgediente Nitrid-Formteile nach einer Zerkleinerung und evtl. Reinigung der gießfähigen Suspension aus Siliciumpulver und $SiO_2$-Sol zugesetzt werden und so den Rohstoffbedarf verringern. Dieses Recycling ist von besonderer Bedeutung, wenn besonders reine Rohstoffe eingesetzt werden, um eine Kontaminierung des flüssigen Siliciums auszuschließen. Die Wiederverwendung der Rohstoffe trägt wesentlich zur Reduktion der Kristallisationskosten bei.

Bis zu 80 Gew.-% der in der gießfähigen Suspension eingesetzten Pulvermenge kann durch solcherart recyclisiertes Material substituiert werden. Entsprechend der zugesetzten Menge recyclisierten Materials können die Intensitätsverhältnisse der eingangs aufgeführten Röntgendiffraktometerreflexe variieren. Bei Zusatz reiner Siliciumnitrid-, Siliciumcarbid-, Siliciumoxynitrid- oder Siliciumdioxid-Phasen sind die Röntgendiffraktometerreflexe dieser Phasen natürlich auch im Endprodukt vorhanden. Auch hier kann bis zu 80 Gew.-% der eingesetzten Pulvergesamtmenge aus Siliciumnitrid-, Siliciumcarbid, Siliciumoxynitrid- oder Siliciumdioxidphasen oder beliebig zusammengesetzten Gemischen dieser Phasen bestehen.

Eine besonders bevorzugte Ausführungsform des erfindungsgemäßen Verfahrens besteht also darin, daß dem Siliciumpulver Siliciumnitrid, Siliciumoxynitrid und/oder Siliciumcarbid in Pulverform in Mengen bis zu 80 Gew.-%, bezogen auf die gesamte Pulvermenge, zugesetzt werden.

Dieses Verfahren zur Herstellung der neuen Werkstoffe ist unabhängig von der Qualität des eingesetzten Siliciums. Der Verunreinigungsgehalt im Silicium kann allerdings bei Einsatz metallurgischer Silicium-Qualitäten zu hoch sein, um eine Verunreinigung der Solarsilicium-Schmelze bei der Kristallisation auszuschließen. In diesem Fall empfiehlt sich eine Vorreinigung des Siliciums.

Für die Bereitstellung qualitativ hochwertiger Werkstoffe empfiehlt sich der Einsatz gereinigten Siliciums, dessen Verunreinigungsgehalt in der Summe < 1000 $ppm_g$, vorzugsweise $\leq$100 $ppm_g$, beträgt.

Es ist weiterhin vorteilhaft, das Siliciumpulver vor dessen Zugabe zum $SiO_2$-Sol einer oxidierenden Behandlung auszusetzen. Dies kann durch Behandlung des Siliciumpulvers mit Luft und/oder Wasserdampf bei Temperaturen zwischen 40 und 350°C geschehen, ebenso durch eine Behandlung mit einer wäßrigen $H_2O_2$-Lösung bei Temperaturen von 20 bis 100°C.

Als Suspensions- und Bindemittel kommen im Sinne der Erfindung alle handelsüblichen $SiO_2$-Sole in Frage, wobei Kieselsole mit $SiO_2$-Gehalten von 15 - 40 % und pH-Werten von 3,4 - 10 bevorzugt werden. Bei Einsatz alkalisch eingestellter Kieselsole empfiehlt es sich, das Siliciumpulver durch Behandlung mit Luft bei höherer Temperatur oder mit wäßrigem $H_2O_2$ zu phlegmatisieren.

Zur Gelierung und Aushärtung der Gießmasse wird die Empfindlichkeit der Kieselsole gegenüber Elektrolytzusätzen, wie z. B. Säuren, Basen, Ammoniumsalzen, Fluoriden oder Erdalkalioxiden, ausgenutzt. Hier haben sich insbesondere Ammoniumsalze bewährt, da sie vor oder während des Nitridierprozesses rückstandslos ausgeheizt werden können und daher keine zusätzliche Kontaminationsquelle beim späteren Einsatz der Formteile zur Handhabung von chemisch sehr reinen Siliciumschmelzen bilden.

Das Verhältnis von Feststoff zu $SiO_2$-Sol ist für die Dichte der entsprechenden Formteile ebenso von Bedeutung wie die Partikelgrößenverteilung der eingesetzten Siliciumpulver oder die Art und Menge der zugesetzten Fremdphasenmaterialien wie Siliciumcarbid, Siliciumnitrid oder Siliciumoxynitrid. Die Viskosität der zu vergießenden Suspension sollte so hoch eingestellt werde, daß keine Entmischung von fein- und grobteiligen Partikeln eintritt.

Nach Gelierung und Aushärtung der Gießmasse in der Gußform kann das Werkstück ausgeformt und getrocknet werden. Die Trocknung muß besonders schonend durchgeführt werden, um eine Rißbildung in den Formteilen zu vermeiden. Im allgemeinen ist es günstig, die Formteile nach der Entformung zunächst eine Woche bei Raumtemperatur an Umgebungsluft zu trocknen. Die Trocknungsgeschwindigkeit ist abhängig von Formteilparametern, wie z. B. Größe und Wandstärke des Formteils, so daß der angegebene Zeitraum nur ein Richtwert sein kann.

Um kompliziertere Formteile besonders schonend zu trocknen, kann es im Sinne der Erfindung auch sinnvoll sein, den Trocknungsprozeß in Kammern definierter Luftfeuchtigkeit durchzuführen. Nach diesem ersten Trocknungsschritt kann sich ein zweiter Trocknungsschritt, der bei höheren Temperaturen und ggf. unter reduziertem Druck durchgeführt wird, anschließen. Die so erhaltenen Formteile sind im Grünzustand stabil und können mechanisch bearbeitet werden.

Die Nitridierung der Grünlinge erfolgt im Temperaturbereich zwischen 1300 °C und 1480 °C in einer Atmosphäre, die aus reinem Stickstoff, Stickstoff/Edelgas-, Stickstoff/Wasserstoff-, Stickstoff/Wasserdampf, Stickstoff/Wasserstoff/Wasserdampf, Stickstoff/Ammoniak- oder Stickstoff/Wasserstoff/Ammoniak-Gasgemischen bestehen kann. Während des Nitridierprozesses ist es günstig, die Temperatur stufenweise oder kontinuierlich von 1300 °C auf 1400 °C zu erhöhen. Die Nitridierung kann im Sinne der Erfindung durch eine Temperatursteigerung über den Schmelzpunkt des Siliciums hinaus auf 1480 °C abgeschlossen werden. Die Dauer der Nitridierung richtet sich nach Formteilparametern, wie z. B. Größe und Wandstärke des Formteiles; allgemein ist die Nitridierung jedoch nach einer Reaktionszeit von 40 - 100 h beendet. Die so erhaltenen nitridierten Formteile sind - falls erforderlich - mechanisch leicht zu bearbeiten und eignen sich zur Handhabung von Siliciumschmelzen, die z. B. die zur Herstellung von Solarzellen erforderlichen Reinheitskriterien erfüllen.

Soll der Werkstoff bei Temperaturen unterhalb von 1400 °C eingesetzt werden, kann es aus ökonomischen Gründen sinnvoll sein, durch kurze Nitridierzeiten Formteile mit einem hohen Gehalt an freiem elementarem Silicium herzustellen. Ein besonderer Vorteil der nach dem beanspruchten Verfahren hergestellten Formteile ist, daß die Formteile während der Nitridierung formstabil bleiben und keine nennenswerte Schwindung oder Ausdehnung zeigen.

Aufgrund ihrer hervorragenden Eigenschaften sind die erfindungsgemäßen Werkstoffe besonders gut für die Herstellung von Tiegeln für die Behandlung von Salz- und Metallschmelzen, deren Schmelzpunkt 1800 °C nicht überschreitet, geeignet.

Gegenstand der vorliegenden Erfindung sind somit die Verwendung der erfindungsgemäßen Werkstoffe zur Herstellung von Tiegeln zum Schmelzen und Kristallisieren von Metall, insbesondere von Silicium, sowie als Werkzeuge bei Handhabung und Schmelzbehandlungen von Metallschmelzen, insbesondere von Siliciumschmelzen sowie die Verwendung zur Herstellung und Kristallisation von Salzschmelzen sowie als Werkzeuge bei Handhabung und Schmelzbehandlungen von Salzschmelzen.

Nachfolgend wird die Erfindung beispielhaft erläutert, ohne daß hierin eine Einschränkung der Erfindung zu sehen ist.

## Beispiel

Siliciumpulver handelsüblicher metallurgischer Qualität wird durch Behandlung mit einem Säuregemisch, das aus 3 - 30 % HCl und 0,5 - 8 % HF besteht, gereinigt. Anschließend wird das Pulver mit destilliertem Wasser säurefrei gewaschen und bei 250 °C unter Luftzufuhr getrocknet. 2730 g dieses Siliciumpulvers werden in 1943 g eines Kieselsols mit 30 % $SiO_2$-Anteil suspendiert. Nach Zusatz von 75 g Siliciumnitrid, Siliciumoxynitrid und/oder Siliciumcarbid werden 114 ml einer wäßrigen Lösung von Ammoniumsulfat (500 g/l) als Geliermittel zugesetzt. Der Geliermittelzusatz ist so bemessen, daß die Aushärtung nach ca. 4 min einsetzt.

Die so erhaltene Masse wird in Kunststoff- oder Metallformen gegossen, die die Herstellung von 10 x 10 x 20 cm (Länge x Breite x Höhe; Innenmaße) großen Formteilen mit einer Wandstärke von 0,5 cm ermöglichen. Nach 2 h ist die Aushärtung der Gießmasse soweit fortgeschritten, daß die Formteile, die dem keramischen Sprachgebrauch folgend als Grünlinge bezeichnet werden, ausgeformt werden können. Die Trocknung erfolgt über einen Zeitraum von 7 Tagen bei Raumtemperatur an Umgebungsluft. Abschließend werden die Grünlinge im Vakuumtrockenschrank auf 250°C erhitzt.

Die Nitridierung der Grünlinge erfolgt in einer Stickstoffatmosphäre, wobei im Verlaufe von 66 h die Temperatur kontinuierlich von 1300°C auf 1400°C gesteigert wird. Um die Nitridierung abzuschließen, wird die Temperatur anschließend auf 1480°C erhöht und dort 6 h gehalten.

Ein so erhaltenes nitridiertes Werkstück kann mit allgemein gebräuchlichen Werkzeugen leicht mechanisch bearbeitet werden und kann als Tiegel zur Herstellung einer Siliciumschmelze dienen.

Auf diese Weise können beliebig geformte Werkstücke hergestellt werden, die zur Handhabung von Siliciumschmelzen geeignet sind. Insbesondere können nach diesem Verfahren z. B. Rohre und Schmelztiegel sowie Kokillen hergestellt werden, die nach erfolgter Kristallisation der Siliciumschmelze wiederverwendbar sind.

**Patentansprüche**

1. Werkstoffe, die gegenüber Metallschmelzen und Salzschmelzen resistent sind, dadurch gekennzeichnet, daß sie zu 40-90 Gew.-% aus Siliciumnitrid, 2-20 Gew.-% Siliciumdioxid, 2-20 Gew.-% Siliciumoxynitrid und 2-20 Gew.-% elementarem Silicium bestehen.

2. Werkstoffe, die gegenüber Metallschmelzen und Salzschmelzen resistent sind, dadurch gekennzeichnet, daß sie zu 40-90 Gew.-% aus Siliciumnitrid, 2-20 Gew.-% Siliciumdioxid, 2-20 Gew.-% Siliciumoxynitrid, 2-20 % elementarem Silicium und 15-30 Gew.-% Siliciumcarbid bestehen.

3. Verfahren zur Herstellung von Werkstoffen gemäß einem der Ansprüche 1 oder 2, dadurch gekennzeichnet, daß Siliciumpulver in $SiO_2$-Sol unter Bildung einer Gießmasse suspendiert, aus dieser ein Werkstück geformt, dieses ausgehärtet und nach dem Ausformen des $SiO_2$-gebundenen Siliciums dieses unter Stickstoffatmosphäre zu Siliciumnitrid und Siliciumoxynitrid so umgesetzt wird, daß im nitridierten Werkstück $SiO_2$ und elementares Silicium nachweisbar bleiben, wobei diese Aushärtung der Gießmasse ggf. unter Einsatz von Säuren, Basen, Fluoriden, Erdalkalioxiden und/oder Ammoniumsalzen geschehen kann, wobei diese im Laufe des Verfahrens rückstandslos ausgeheizt werden.

4. Verfahren gemäß Anspruch 3, dadurch gekennzeichnet, daß dem Siliciumpulver, Siliciumnitrid, Siliciumoxidnitrid und/oder Siliciumcarbid in Pulverform in Mengen bis zu 80 Gew.-%, bezogen auf die gesamte Pulvermenge, zugesetzt werden.

5. Verfahren gemäß einem der Ansprüche 3 oder 4, dadurch gekennzeichnet, daß das Siliciumpulver vor dessen Zugabe zum $SiO_2$-Sol einer oxidierenden Behandlung ausgesetzt wird.

6. Verfahren gemäß einem oder mehreren der Ansprüche 3 bis 5, dadurch gekennzeichnet, daß die Nitridierung bei Temperaturen von 1300 bis 1480°C unter Stickstoff, bevorzugt unter Zusatz von Ammoniak, Wasserstoff und/oder Wasserdampf, erfolgt.

7. Verwendung der Werkstoffe gemäß einem oder mehreren der Ansprüche 1 bis 6 zur Herstellung von Tiegeln zum Schmelzen und Kristallisieren von Metall, insbesondere von Silicium, sowie als Werkzeuge bei Handhabung und Schmelzbehandlungen von Metallschmelzen, insbesondere von Siliciumschmelzen.

8. Verwendung der Werkstoffe gemäß einem oder mehrerer der Ansprüche 1 bis 6 zur Herstellung und Kristallisation von Salzschmelzen sowie als Werkzeuge bei Handhabung und Schmelzbehandlungen von Salzschmelzen.

**Claims**

1. Materials resistant to metal melts and salt melts, characterized in that they consist of 40 to 90% by weight silicon nitride, 2 to 20% by weight silicon dioxide, 2 to 20% by weight silicon oxynitride and 2 to 20% by weight elemental silicon.

**2.** Materials resistant to metal melts and salt melts, characterized in that they consist of 40 to 90% by weight silicon nitride, 2 to 20% by weight silicon dioxide, 2 to 20% by weight silicon oxynitride, 2 to 20% elemental silicon and 15 to 30% by weight silicon carbide.

**3.** A process for the production of the materials claimed in claim 1 or 2, characterized in that silicon powder is suspended in $SiO_2$ sol to form a pourable mass, a workpiece is formed from that mass and cured and, after the $SiO_2$-bound silicon has been removed from the mould, it is reacted in a nitrogen atmosphere to form silicon nitride and silicon oxynitride in such a way that $SiO_2$ and elemental silicon remain detectable in the nitrided workpiece, curing of the pourable mass optionally being carried out in the presence of acids, bases, fluorides, alkaline earth metal oxides and/or ammonium salts which are completely heated out during the process.

**4.** A process as claimed in claim 3, characterized in that silicon nitride, silicon oxynitride and/or silicon carbide in powder form are added to the silicon powder in quantities of up to 80% by weight, based on the total quantity of powder.

**5.** A process as claimed in claim 3 or 4, characterized in that the silicon powder is subjected to an oxidizing treatment before it is added to the $SiO_2$ sol.

**6.** A process as claimed in one or more of claims 3 to 5, characterized in that the nitriding process is carried out at 1,300 to 1,480°C in a nitrogen atmosphere, preferably with addition of ammonia, hydrogen and/or steam.

**7.** The use of the materials according to one or more of claims 1 to 6 for the production of crucibles for the melting and crystallization of metals, particularly silicon, and as tools in the handling and treatment of metal melts, particularly silicon melts.

**8.** The use of the materials according to one or more of claims 1 to 6 for the production and crystallization of salt melts and as tools in the handling and treatment of salt melts.

**Revendications**

**1.** Matériaux qui résistent aux bains de fusion de métaux et aux bains de fusion de sels, caractérisés en ce qu'ils sont composés à 40-90 % en poids de nitrure de silicium, 2-20 % en poids de dioxyde de silicium, 2-20 % en poids d'oxynitrure de silicium et 2-20 % en poids de silicium élémentaire.

**2.** Matériaux qui résistent aux bains de fusion de métaux et aux bains de fusion de sels, caractérisés en ce qu'ils sont composés à 40-90 % en poids de nitrure de silicium, 2-20 % en poids de dioxyde de silicium, 2-20 % en poids d'oxynitrure de silicium, 2-20 % en poids de silicium élémentaire et 15-30 % en poids de carbure de silicium.

**3.** Procédé de préparation de matériaux selon l'une des revendications 1 ou 2, caractérisé en ce qu'on met la poudre de silicium en suspension dans un sol de $SiO_2$ en formant une masse à couler, on en moule une pièce, on la durcit et, après avoir démoulé le silicium lié au $SiO_2$, on le transforme sous atmosphère d'azote en nitrure de silicium et en oxynitrure de silicium de façon à ce que, dans la pièce nitrurée, le $SiO_2$ et le silicium élémentaire restent décelables, ce durcissement de la masse à couler pouvant s'effectuer éventuellement en présence d'acides, de bases, de fluorures, d'oxydes de métaux alcalino-terreux et/ou de sels d'ammonium, ceux-ci étant éliminés par chauffage sans résidus au cours du procédé.

**4.** Procédé selon la revendication 3, caractérisé en ce que l'on ajoute à la poudre de silicium du nitrure de silicium, de l'oxynitrure de silicium et/ou du carbure de silicium sous forme de poudre en des quantités pouvant aller jusqu'à 80 % en poids de la quantité totale de poudre.

**5.** Procédé selon l'une des revendications 3 et 4, caractérisé en ce qu'on soumet la poudre de silicium à un traitement oxydant avant de l'ajouter au sol de $SiO_2$.

**6.** Procédé selon l'une ou plusieurs des revendications 3 à 5, caractérisé en ce qu'on effectue la nitruration à des températures de 1300 à 1480°C sous azote, de préférence en ajoutant de l'ammoniac, de l'hydrogène et/ou de la vapeur d'eau.

7. Application des matériaux selon l'une ou plusieurs des revendications 1 à 6 à la fabrication de creusets pour la fusion et la cristallisation de métal, en particulier de silicium, et comme instruments pour la manipulation et les traitements de fusion de bains de fusion de métaux, en particulier de bains de fusion de silicium.

8. Application des matériaux selon l'une ou plusieurs des revendications 1 à 6 à la préparation et à la cristallisation de bains de fusion de sels et comme outils pour la manipulation et les traitements de fusion de bains de fusion de sels.